# EUROPEAN PATENT SPECIFICATION

(11) **EP 4 307 361 B1**
(45) Date of publication and mention of the grant of the patent: **11.11.2026**
(21) Application number: 22767285.4
(22) Date of filing: 11.03.2022
(51) Int. Cl.: H05K 3/44, H05K 1/05, H10W 40/25, H10W 70/692, H05K 1/02, H10W 72/30

(54) **HEAT SINK-INTEGRATED INSULATING CIRCUIT BOARD**
IN EINEN KÜHLKÖRPER INTEGRIERTE ISOLIERENDE LEITERPLATTE
CARTE DE CIRCUIT IMPRIMÉ D'ISOLATION INTÉGRÉE À UN DISSIPATEUR THERMIQUE

(30) Priority: 12.03.2021 JP 2021040439
(43) Date of publication of application: 17.01.2024
(73) Proprietor: Mitsubishi Materials Corporation, Tokyo 100-8117 (JP)
(72) Inventor: OHASHI, Toyo, Saitama-shi, Saitama 330-8508 (JP); KUROMITSU, Yoshiro, Naka-shi, Ibaraki 311-0102 (JP); IWAZAKI, Wataru, Saitama-shi, Saitama 330-8508 (JP); SAKANIWA, Yoshiaki, Saitama-shi, Saitama 330-8508 (JP)
(74) Representative: Hoffmann Eitle
(86) International application number: PCT/JP2022/011092
(87) International publication number: WO 2022/191331

(56) References cited:
- EP-A1- 3 780 085
- JP-A- 2012 109 315
- JP-A- 2013 229 545
- JP-A- 2014 060 215
- JP-A- 2020 136 349
- JP-A- 2020 136 349
- US-A1- 2017 309 499
- US-A1- 2020 187 385

## Description

### TECHNICAL FIELD

The present invention relates to a heat sink integrated insulating circuit substrate including a heat sink, an insulating resin layer formed on a top plate part of the heat sink, and a circuit layer formed on one surface of the insulating resin layer.

### BACKGROUND ART

A power module, an LED module, and a thermoelectric module have a structure in which a power semiconductor element, an LED element, and a thermoelectric element are bonded to an insulating circuit substrate in which a circuit layer made of a conductive material formed on one surface of an insulating layer. As the insulating layer, one using ceramics or one using an insulating resin has been proposed.

As the insulating circuit substrate including the insulating resin layer, for example, JP H11-204700 A proposes a heat sink integrated insulating circuit substrate in which a heat sink and a circuit layer are insulated by an insulating resin sheet.

Further, JP 2019-041111 A discloses a composite part in which a cooling base substrate is adhered to at least one surface of a heat generation member via a heat conductive insulating adhesive film. In JP 2019-041111 A, a relationship between shear adhesive strength and thermal stress and a relationship between breaking elongation and thermal strain are defined in order to suppress an occurrence of a crack in the heat conductive insulating adhesive film due to stress generated from the expansion or contraction of a cooling member and the heat generation member due to a temperature change.

Further heat sink integrated insulating circuit structures are shown in US 2017/309499 A1, EP 3780085 A1, JP 2012 109315 A, JP 2020 136349 A and US 2020/187385 A1.

### SUMMARY OF INVENTION

### Technical Problem

Meanwhile, in a heat sink integrated insulating circuit substrate in which an insulating resin layer is formed on a top plate part of a heat sink and a circuit layer is formed on the insulating resin layer, stress may be generated in a direction perpendicular to a surface due to a temperature change, and warpage may occur.

When the heat sink integrated insulating circuit substrate is warped, there is a concern that the end of the circuit layer is peeled from the insulating resin layer or such peeling proceeds to the inside of the insulating resin layer.

Here, in JP 2019-041111 A, the stress and strain in the surface are evaluated, but the stress in the direction perpendicular to the surface is not considered. Therefore, the peeling of the circuit layer and the internal peeling of the insulating resin layer are not supported.

The present invention has been made in view of the above-described circumstances, and an objective of the present invention is to provide a heat sink integrated insulating circuit substrate capable of suppressing an occurrence of peeling between a circuit layer and an insulating resin layer or an occurrence of internal peeling of the insulating resin layer and having excellent reliability, by suppressing generation of stress in a direction perpendicular to a surface due to a temperature change.

### Solution to Problem

As a result of intensive studies by the present inventors in order to solve the above-described problems, it was found that it is possible to reduce stress in a direction perpendicular to a surface due to a temperature change by optimizing the thickness ratio between a copper layer and an aluminum layer.

That is, the top plate part of the heat sink is configured to have a cladding structure in which a copper layer and an aluminum layer are laminated, the thickness of the copper layer and the thickness of the aluminum layer are changed, and the stress in the direction perpendicular to the surface due to the temperature change is thermally calculated. **In** this manner, the appropriate ranges of such thicknesses are obtained.

The present invention has been made based on the above findings. A heat sink integrated insulating circuit substrate according to an aspect of the present invention (referred to as a heat sink integrated insulating circuit substrate below) includes a heat sink, an insulating resin layer formed on a top plate part of the heat sink, and a circuit layer formed on one surface of the insulating resin layer. The circuit layer is formed of copper or a copper alloy. The top plate part of the heat sink has a cladding structure including an aluminum layer made of aluminum or an aluminum and a copper layer laminated on the aluminum layer. The insulating resin layer is formed on a surface of the copper layer, and a ratio ta/tc between a thickness ta of the aluminum layer and a thickness tc of the copper layer is equal to or less than 30.

According to the heat sink integrated insulating circuit substrate having such a configuration, since the top plate part of the heat sink has the cladding structure in which the copper layer and the aluminum layer are laminated, and the ratio ta/tc between the thickness ta of the aluminum layer and the thickness tc of the copper layer is set to be equal to or less than 30, it is possible to reduce stress in a direction perpendicular to a surface, which is generated due to a temperature change, and to suppress an occurrence of peeling between the circuit layer and the insulating resin layer or an occurrence of internal peeling in the insulating resin layer.

Here, in the heat sink integrated insulating circuit substrate in the present invention, the insulating resin layer preferably contains a filler made of an inorganic material.

**In** this case, since the thermal conductivity of the insulating resin layer is secured, it is possible to efficiently transfer heat from a heat source mounted on the circuit layer to the heat sink side, and to efficiently cool on the heat sink side.

Further, in the heat sink integrated insulating circuit substrate in the present invention, the heat sink includes a cooling fin protruding from the surface of the top plate part.

In this case, cooling characteristics in the heat sink are improved, and it is possible to efficiently cool to radiate heat from the heat source mounted on the circuit layer to the heat sink side.

### ADVANTAGEOUS EFFECTS OF INVENTION

According to the present invention, it is possible to provide a heat sink integrated insulating circuit substrate capable of suppressing an occurrence of peeling between the circuit layer and the insulating resin layer or an occurrence of internal peeling of the insulating resin layer and having excellent reliability, by suppressing generation of stress in a direction perpendicular to a surface due to a temperature change.

### BRIEF DESCRIPTION OF DRAWINGS

FIG. 1 is a schematic diagram of a power module including a heat sink integrated insulating circuit substrate according to an embodiment of the present invention.
FIG. 2 is a flowchart representing an example of a method of manufacturing a heat sink integrated insulating circuit substrate according to the embodiment of the present invention.
FIG. 3 is a schematic diagram of a method of manufacturing the heat sink integrated insulating circuit substrate according to the embodiment of the present invention.
FIG. 4 is a schematic diagram of the method of manufacturing the heat sink integrated insulating circuit substrate according to the embodiment of the present invention.

### DESCRIPTION OF EMBODIMENTS

Hereinafter, an embodiment of the present invention will be described with reference to the accompanying drawings.

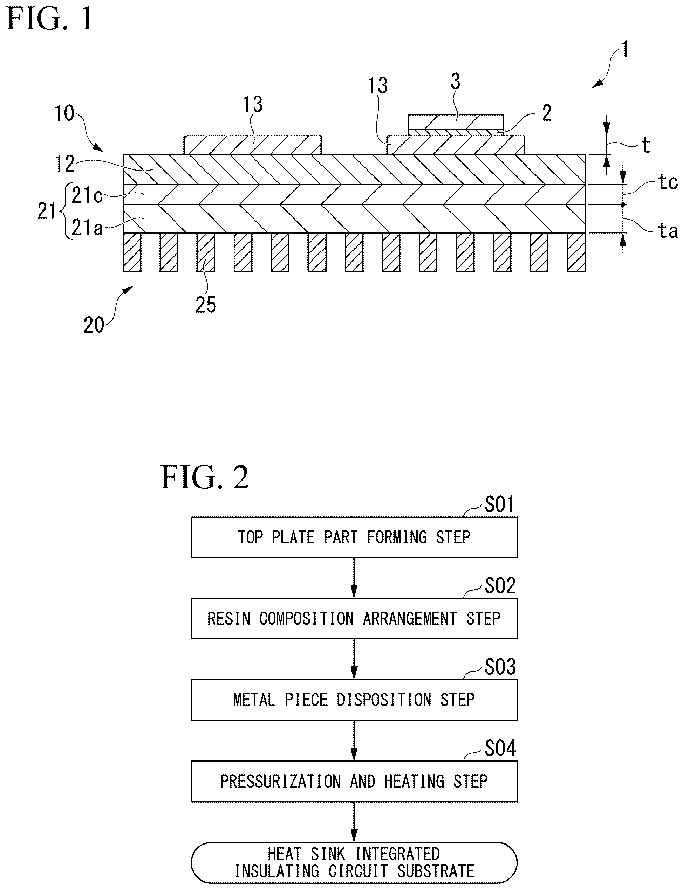

FIG. 1 represents a heat sink integrated insulating circuit substrate 10 and a power module 1 using the heat sink integrated insulating circuit substrate 10 according to an embodiment of the present invention.

The power module 1 represented in FIG. 1 includes the heat sink integrated insulating circuit substrate 10 and a semiconductor element 3 bonded to one surface (upper surface in FIG. 1) of the heat sink integrated insulating circuit substrate 10 via a solder layer 2.

The semiconductor element 3 is made of a semiconductor material such as Si. The solder layer 2 that bonds the heat sink integrated insulating circuit substrate 10 and the semiconductor element 3 to each other is made of, for example, an Sn-Ag-based, Sn-Cu-based, Sn-In-based, or Sn-Ag-Cu-based solder material (so-called a lead-free solder material).

The insulating resin layer 12 prevents an electrical connection between the circuit layer 13 and the heat sink 20, and is made of an insulating resin.

In the present embodiment, it is preferable to use a resin containing a filler made of an inorganic material in order to secure the strength of the insulating resin layer 12 and to secure the thermal conductivity. Here, as the filler, for example, alumina, boron nitride, aluminum nitride, or the like can be used. From the viewpoint of securing the thermal conductivity in the insulating resin layer 12, the content of the filler is preferably 70 mass% or more, and more preferably 80 mass% or more.

Further, as a thermosetting resin, an epoxy resin, a polyimide resin, a silicon resin, or the like can be used. Here, when the thermosetting resin is an epoxy resin, the thermosetting resin can contain 70 mass% or more of the filler, and, when the thermosetting resin is a silicon resin, the thermosetting resin can contain 80 mass% or more of the filler.

In order to sufficiently secure the insulating property of the insulating resin layer 12, the thickness of the insulating resin layer 12 is preferably set to 50 µm or more, and more preferably 100 µm or more. On the other hand, in order to further secure the cooling performance in the heat sink integrated insulating circuit substrate 10, the thickness of the insulating resin layer 12 is preferably set to 250 µm or less, and more preferably 150 µm or less.

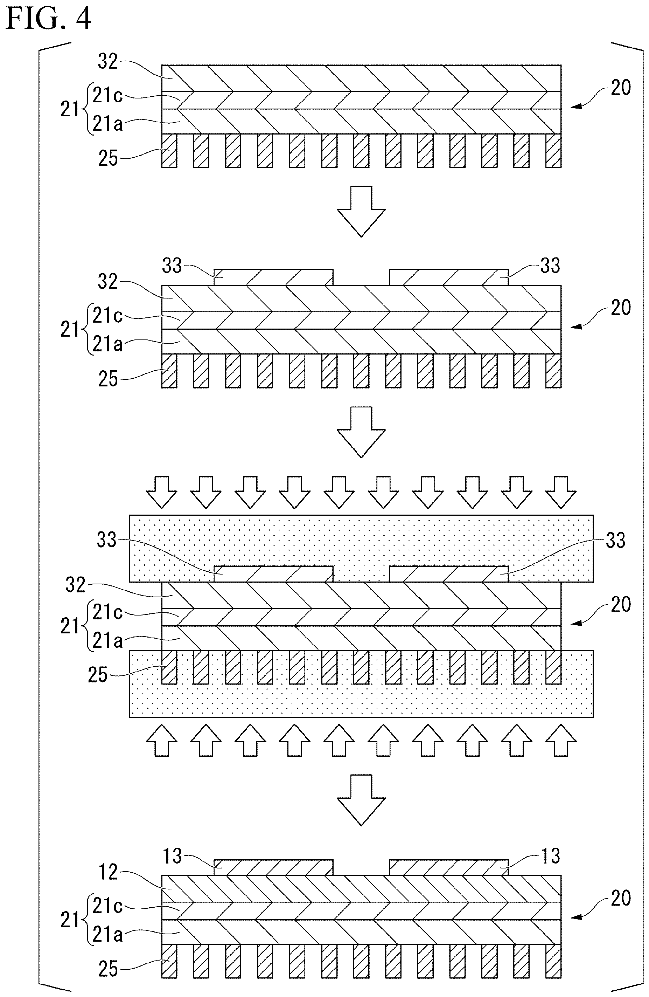

As represented in FIG. 4, the circuit layer 13 is formed by bonding a metal piece 33 to one surface (upper surface in FIG. 4, that is, a surface opposite to the heat sink 20) of the insulating resin layer 12. The metal piece 33 is made of copper or a copper alloy with excellent conductivity. As the metal piece 33 constituting the circuit layer 13, for example, a metal piece obtained by punching out a rolled plate of oxygen-free copper (OFC) is used.

In this circuit layer 13, a circuit pattern is formed, and one surface (upper surface represented in FIG. 1) thereof is a mounting surface on which the semiconductor element 3 is mounted.

Here, the thickness t of the circuit layer 13 is preferably set within a range of 0.1 mm or more and 3.0 mm or less. By setting the thickness t of the circuit layer 13 to 0.1 mm or more, it is possible to sufficiently expand the heat generated by the semiconductor element 3. On the other hand, by setting the thickness t of the circuit layer 13 to 3.0 mm or less, it is possible to suppress an occurrence of problems such as deterioration in accuracy of forming a circuit pattern and deterioration in manufacturing efficiency.

The thickness t of the circuit layer 13 is further preferably set to 0.3 mm or more, and more preferably set to 0.5 mm or more in order to secure cooling performance. Further, the thickness t of the circuit layer 13 is further preferably set to 2.5 mm or less, and more preferably set to 2.0 mm or less.

The heat sink integrated insulating circuit substrate 10 includes a heat sink 20, an insulating resin layer 12 formed on one surface (upper surface in FIG. 1) of a top plate part 21 of the heat sink 20, and a circuit layer 13 formed on one surface (upper surface in FIG. 1) of the insulating resin layer 12. The above-described semiconductor element 3 is bonded to one surface (upper surface in FIG. 1) of the circuit layer 13.

The heat sink 20 includes the top plate part (plate-shaped member) 21 and a cooling fin 25 protruding from the other surface (lower surface in FIG. 1) of the top plate part 21.

The heat sink 20 has a configuration in which heat is spread in the top plate part 21 in a surface direction and is radiated to the outside via the cooling fin 25.

As represented in FIG. 1, the top plate part 21 of the heat sink 20 has a cladding structure in which the copper layer 21c and the aluminum layer 21a are laminated, and the insulating resin layer 12 is formed on the surface of the copper layer 21c.

The copper layer 21c is formed of pure copper or a copper alloy and is formed of oxygen-free copper in the present embodiment.

The aluminum layer 21a is formed of pure aluminum or an aluminum alloy, and is formed of the A6063 alloy in the present embodiment. An aluminum alloy such as A3003 can be used in addition to A6063. As pure aluminum, 2N-Al having a purity of 99 mass% or more, 3N-Al having a purity of 99.9 mass% or more, 4N-Al having a purity of 99.99 mass% or more, or the like can be used.

A ratio ta/tc between the thickness ta of the aluminum layer 21a and the thickness tc of the copper layer 21c, the aluminum layer 21a and the copper layer 21c constituting the top plate part 21, is set to be equal to or less than 30. When the ratio ta/tc exceeds 30, peeling occurs from the end of an interface between metal (copper layer 21c) and resin due to thermal stress caused by a difference in linear expansion of the member during the heat treatment.

Here, the ratio ta/tc between the thickness ta of the aluminum layer 21a and the thickness tc of the copper layer 21c is preferably equal to or less than 20, and more preferably equal to or less than 10. The lower limit of the ratio ta/tc between the thickness ta of the aluminum layer 21a and the thickness tc of the copper layer 21c is not particularly limited, but is preferably equal to or more than 0.1, and more preferably equal to or more than 0.5.

In addition, in the present embodiment, the thickness tc of the copper layer 21c constituting the top plate part 21 is preferably set within a range of 0.1 mm or more and 3.0 mm or less. By setting the thickness tc of the copper layer 21c to 0.1 mm or more, the copper layer 21c is entirely changed to an intermetallic compound when a cladding structure in which the aluminum layer 21a and the copper layer 21c are laminated by diffusion-in-solids bonding is formed. Thus, it is possible to suppress the deterioration of the cooling performance. On the other hand, by setting the thickness tc of the copper layer 21c to 3.0 mm or less, it is possible to suppress an occurrence of a problem in terms of the workability of copper.

Here, the thickness tc of the copper layer 21c is further preferably equal to or more than 0.3 mm, and more preferably equal to or more than 0.5 mm. Further, the thickness tc of the copper layer 21c is further preferably equal to or less than 3.0 mm, and more preferably equal to or less than 2.0 mm.

In addition, in the present invention, the thickness ta of the aluminum layer 21a constituting the top plate part 21 is set within a range of 2.0 mm or more and 4.0 mm or less. By setting the thickness ta of the aluminum layer 21a to 2.0 mm or more, it is possible to suppress an occurrence of a problem on the machined surface of the fins. On the other hand, by setting the thickness ta of the aluminum layer 21a to 4.0 mm or less, it is possible to suppress the deterioration of the cooling performance.

The cooling fin 25 is connected to the aluminum layer 21a. In the present embodiment, the cooling fin 25 is also formed of the same material (A6063 alloy) as the aluminum layer 21a. The cooling fin 25 may be formed of a material different from the material of the aluminum layer 21a.

In addition, the cooling fin 25 may have a pin-fin structure, a comb-shaped structure, or another structure. It is preferable that a volume ratio occupied by the cooling fin 25 in a place where the cooling fin 25 is formed is set to be within a range of 10% or more and 40% or less.

Next, a method of manufacturing the heat sink integrated insulating circuit substrate 10 in the present embodiment will be described with reference to FIGS. 2 to 4.

### (Top Plate Part Forming Step S01)

First, the top plate part 21 having a cladding structure in which the aluminum layer 21a and the copper layer 21c are laminated is formed.

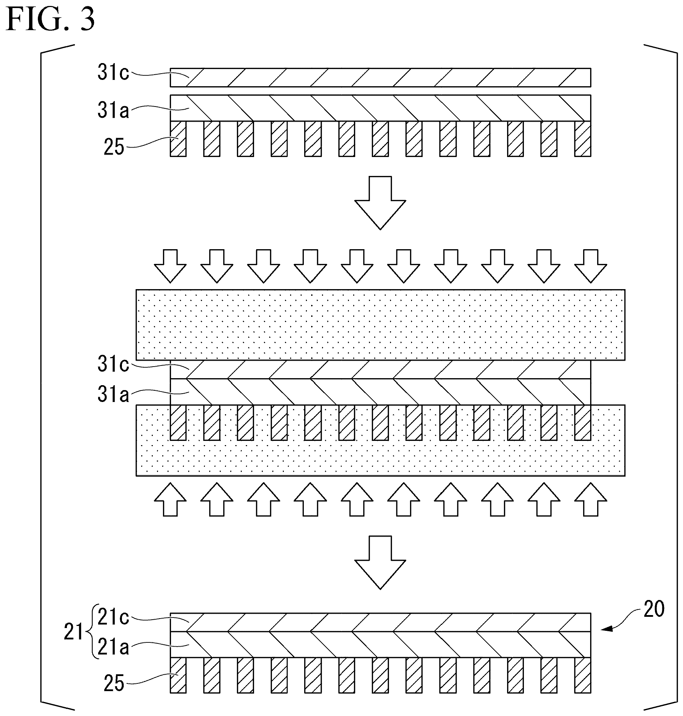

In the present embodiment, as represented in FIG. 3, an aluminum sheet 31a and a copper sheet 31c are laminated, and the aluminum sheet 31a and the copper sheet 31c are subjected to diffusion-in-solids bonding by pressurizing and heating the aluminum sheet 31a and the copper sheet 31c in a laminating direction. In this manner, the top plate part 21 having the cladding structure is formed. In the present embodiment, as represented in FIG. 3, the aluminum sheet 31a is bonded to the copper sheet 31c in a state where a cooling fin 25 is formed on the aluminum sheet 31a.

Here, the conditions for diffusion-in-solids bonding between the aluminum sheet 31a and the copper sheet 31c are preferably set as follows: a heating temperature is within a range of 400°C or higher and lower than 548°C, a pressurizing load is within a range of 0.1 MPa or more and 3.5 MPa or less, and a retention time is within a range of 5 minutes or longer and 240 minutes or shorter.

### (Resin Composition Arrangement Step S02)

Then, as represented in FIG. 4, a resin composition 32 containing a filler made of an inorganic material, a resin, and a curing agent is arranged on one surface (upper surface in FIG. 4) of the top plate part 21 (copper layer 21c) of the heat sink 20. In the present embodiment, the resin composition 32 is in a form of a sheet.

### (Metal Piece Disposition Step S03)

Then, a plurality of metal pieces 33 serving as the circuit layer 13 are disposed in a circuit pattern on one surface (upper surface in FIG. 4) of the resin composition 32.

### (Pressurization and Heating Step S04)

Then, the heat sink 20, the resin composition 32, and the metal piece 33 are pressurized and heated in the laminating direction by a pressurizing device to cure the resin composition 32 and form the insulating resin layer 12. In addition, the top plate part 21 (copper layer 21c) of the heat sink 20 and the insulating resin layer 12 are bonded to each other, and the insulating resin layer 12 and the metal piece 33 are bonded to each other.

In the pressurization and heating step S04, it is preferable that a heating temperature is set within a range of 120°C or higher and 350°C or lower, and a retention time at the heating temperature is set within a range of 10 minutes or longer and 180 minutes or shorter. Further, it is preferable that the pressurizing load in the laminating direction is set within a range of 1 MPa or more and 30 MPa or less.

Here, the lower limit of the heating temperature is further preferably set to 150°C or higher, and more preferably 170°C or higher. On the other hand, the upper limit of the heating temperature is further preferably 250°C or lower, and more preferably 200°C or lower.

The lower limit of the retention time at the heating temperature is further preferably set to 30 minutes or longer, and more preferably set to 60 minutes or longer. On the other hand, the upper limit of the retention time at the heating temperature is further preferably set to 120 minutes or shorter, and more preferably set to 90 minutes or shorter.

The lower limit of the pressurizing load in the laminating direction is further preferably set to 5 MPa or more, and more preferably set to 8 MPa or more. On the other hand, the upper limit of the pressurizing load in the laminating direction is further preferably set to 15 MPa or less, and more preferably set to 10 MPa or less.

With each step described above, the heat sink integrated insulating circuit substrate 10 according to the present embodiment is manufactured.

According to the heat sink integrated insulating circuit substrate 10 having a configuration described above according to the present embodiment, since the top plate part 21 of the heat sink 20 has the cladding structure in which the copper layer 21c and the aluminum layer 21a are laminated, and the ratio ta/tc between the thickness ta of the aluminum layer 21a and the thickness tc of the copper layer 21c is set to be equal to or less than 30, it is possible to reduce stress in a direction perpendicular to a surface, which is generated due to a temperature change, and to suppress an occurrence of peeling between the circuit layer 13 and the insulating resin layer 12 or an occurrence of internal peeling of the insulating resin layer 12.

In the present embodiment, since the insulating resin layer 12 contains the filler made of an inorganic material, the thermal conductivity of the insulating resin layer 12 is secured, and it is possible to efficiently transfer the heat from the semiconductor element 3 mounted on the circuit layer 13 to the heat sink 20 side.

Further, in the present embodiment, since the heat sink 20 includes the cooling fin 25, the cooling characteristics of the heat sink 20 are improved, and it is possible to efficiently cool to radiate the heat from the semiconductor element 3 mounted on the circuit layer 13 to the heat sink 20 side.

In the present embodiment, a case where the heat sink integrated insulating circuit substrate is manufactured by using the method of manufacturing the heat sink integrated insulating circuit substrate represented in FIGS. 2 to 4 has been described, but the present invention is not limited thereto.

For example, in the present embodiment, a case where the top plate part having a cladding structure is formed by performing diffusion-in-solids bonding of a copper sheet and an aluminum sheet has been described. The present invention is not limited thereto, and the top plate part having the cladding structure may be formed by plating a copper layer on the surface of an aluminum sheet.

Further, in the present embodiment, a case where the semiconductor element is configured to be mounted on the heat sink integrated insulating circuit substrate to form the power module has been described, but the present invention is not limited thereto. For example, an LED element may be mounted on the circuit layer of the heat sink integrated insulating circuit substrate to form an LED module, or a thermoelectric element may be mounted on the circuit layer of the heat sink integrated insulating circuit substrate to form a thermoelectric module.

In addition, in the present embodiment, a case where the insulating resin layer contains the filler of the inorganic material has been described. The present invention is not limited thereto, and the insulating resin layer may not contain the filler of the inorganic material.

### [Examples]

The results of the confirmation experiment conducted to confirm the effect of the present invention will be described below, with reference to the examples described in Table 1. While examples 1-5, 7-10, 13-14 are within the scope of the present invention, examples 6, 11-12 are out of the scope of the present invention, but useful to understand it.

A sheet material of a resin composition shown in Table 1 was disposed on the top plate part (50 mm × 50 mm, thickness is shown in Table 1) of the heat sink having the structure shown in Table 1, and a metal piece forming the circuit layer shown in Table 1 was disposed on the sheet material of the resin composition. The heat sink, the sheet material of the resin composition, and the metal piece, which had been laminated, were heated while pressurizing in the laminating direction to cure the resin composition and form the insulating resin layer. Then, a heat sink integrated insulating circuit substrate was obtained by bonding the top plate part of the heat sink and the insulating resin layer and bonding the insulating resin layer and the metal piece. The pressure in the lamination direction was set to 1 MPa, a heating temperature was set to 530°C, and a retention time at the heating temperature was set to 60 minutes. In addition, in Table 1, "Al₂O₃, BN" indicates that a filler in which alumina and BN are mixed at a ratio of 1: 4 (volume ratio) was used.

As described above, the obtained heat sink integrated insulating circuit substrate was evaluated for the following items.

### (Breaking After Heat Treatment)

The obtained heat sink integrated insulating circuit substrate was heat-treated at 300°C for 10 minutes, and the breaking status of the insulating resin layer was confirmed. The heat sink integrated insulating circuit substrate after the heat treatment was cut into a diagonal line of a rectangle when viewed from the top, and 1000 µm × 1000 µm cross-sectional observation is performed. Then, "B" was given when the breaking length in the insulating resin layer is equal to or more than 2% of the diagonal length of the insulating resin layer. In addition, "A" was given when the breaking length is less than 2% of the diagonal length. When breaking occurred at a plurality of places, "B" was given to the case where the maximum breaking length was equal to or more than 2% of the diagonal length, and "A" was given to the case where the maximum breaking length was less than 2% of the diagonal length.

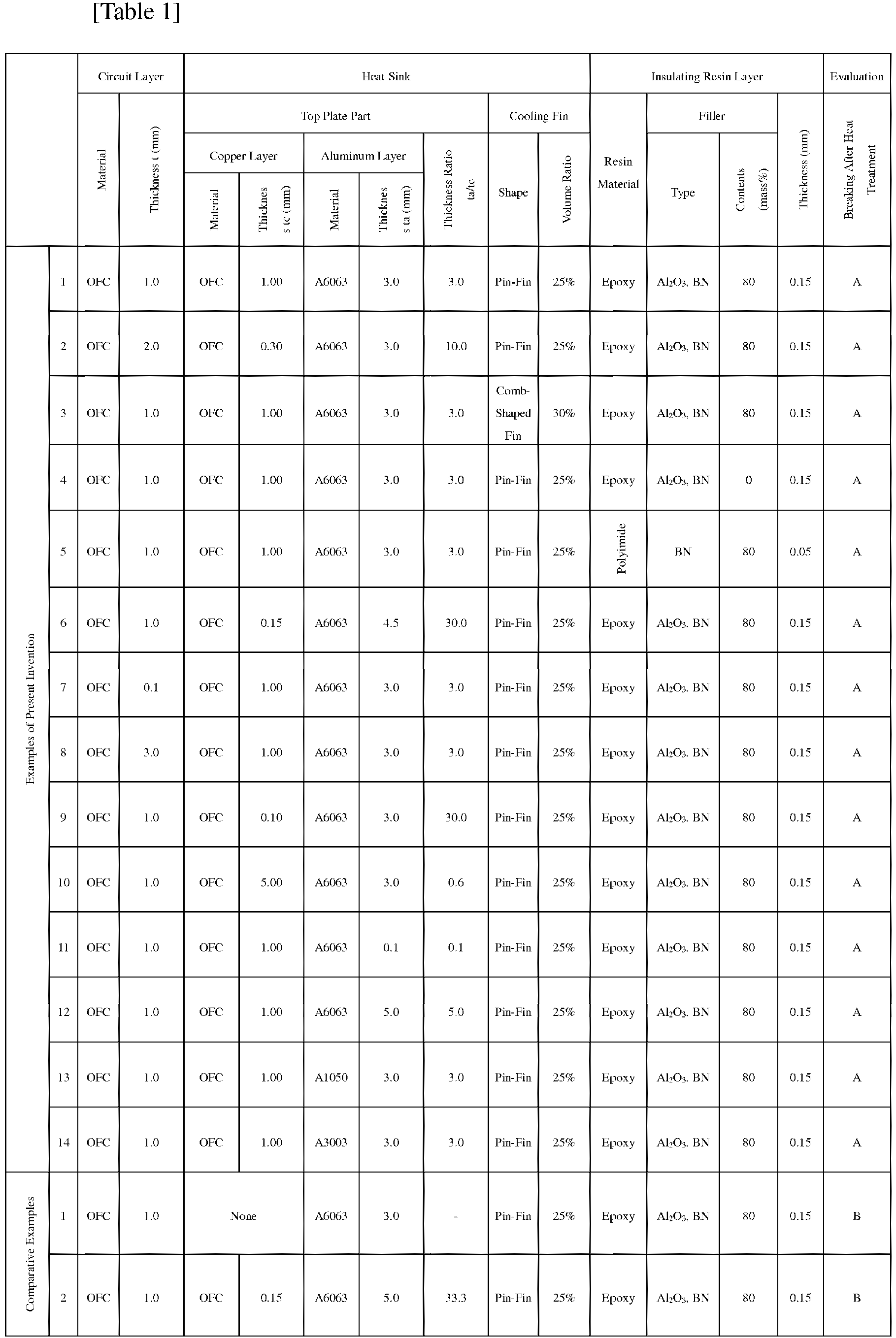

In Comparative Example 1 in which the top plate part was formed only of aluminum, breaking of the insulating resin layer after the heat treatment was confirmed.

In Comparative Example 2 in which the top plate part is made to have a laminated structure of the aluminum layer and the copper layer, and the ratio ta/tc between the thickness ta of the aluminum layer and the thickness tc of the copper layer exceeds 30, breaking of the insulating resin layer after the heat treatment was confirmed.

On the other hand, in Examples 1 to 14 in which the top plate part is made to have a laminated structure of the aluminum layer and the copper layer, and the ratio ta/tc between the thickness ta of the aluminum layer and the thickness tc of the copper layer is equal to or less than 30, it was possible to sufficiently suppress the occurrence of breaking in the insulating resin layer after the heat treatment.

From the above description, according to the examples. it was confirmed that it is possible to provide a heat sink integrated insulating circuit substrate capable of suppressing an occurrence of peeling between the circuit layer and the insulating resin layer or an occurrence of internal peeling of the insulating resin layer and having excellent reliability, by suppressing generation of stress in a direction perpendicular to a surface due to a temperature change.

### [Industrial Applicability]

According to the present invention, it is possible to provide a heat sink integrated insulating circuit substrate capable of suppressing the occurrence of peeling between the circuit layer and the insulating resin layer or internal peeling of the insulating resin layer.

### [Reference Signs List]

10: Heat sink integrated insulating circuit substrate
12: Insulating resin layer
13: Circuit layer
20: Heat sink
21: Top plate part
21c: Copper layer
21a: Aluminum layer
25: Cooling fin

## Claims

1. A heat sink integrated insulating circuit substrate (10) comprising:
a heat sink (20);
an insulating resin layer (12) formed on a top plate part (21) of the heat sink (20); and
a circuit layer (13) formed on one surface of the insulating resin layer (12),
wherein the circuit layer (13) is formed of copper or a copper alloy,
the top plate part (21) of the heat sink (20) has a cladding structure including an aluminum layer (21a) made of aluminum or an aluminum alloy and a copper layer (21c) laminated on the aluminum layer (21a),
the insulating resin layer (12) is formed on a surface of the copper layer (21c),
a ratio ta/tc between a thickness ta of the aluminum layer (21a) and a thickness tc of the copper layer (21c) is equal to or less than 30,
the thickness ta of the aluminum layer (21a) is equal to or more than 2.0 mm and equal to or less than 4.0 mm, and
the heat sink (20) includes a cooling fin (25) protruding from the surface of the top plate part (21).

2. The heat sink integrated insulating circuit substrate (10) according to Claim 1,
wherein the insulating resin layer (12) contains a filler made of an inorganic material.

## Patentansprüche

1. In einen Kühlkörper integriertes isolierendes Leiterplattensubstrat (10), umfassend:
einen Kühlkörper (20);
eine Isolierharzschicht (12), die auf einem Deckplattenabschnitt (21) des Kühlkörpers (20) gebildet ist; und
eine Schaltungsschicht (13), die auf einer Oberfläche der Isolierharzschicht (12) gebildet ist,
wobei die Schaltungsschicht (13) aus Kupfer oder einer Kupferlegierung gebildet ist,
der Deckplattenabschnitt (21) des Kühlkörpers (20) eine Plattierungsstruktur aufweist, die eine Aluminiumschicht (21a) aus Aluminium oder einer Aluminiumlegierung und eine auf der Aluminiumschicht (21a) laminierte Kupferschicht (21c) einschließt,
die Isolierharzschicht (12) auf einer Oberfläche der Kupferschicht (21c) gebildet ist,
ein Verhältnis ta/tc zwischen einer Dicke ta der Aluminiumschicht (21a) und einer Dicke tc der Kupferschicht (21c) kleiner oder gleich 30 ist,
die Dicke ta der Aluminiumschicht (21a) größer oder gleich 2,0 mm und kleiner oder gleich 4,0 mm ist, und
der Kühlkörper (20) eine Kühlrippe (25) einschließt, die von der Oberfläche des Deckplattenabschnitts (21) vorsteht.

2. In einen Kühlkörper integriertes isolierendes Leiterplattensubstrat (10) nach Anspruch 1,
wobei die Isolierharzschicht (12) einen Füllstoff aus einem anorganischen Material enthält.

## Revendications

1. Substrat de circuit d'isolation (10) intégré à un dissipateur thermique, comprenant :
un dissipateur thermique (20) ;
une couche de résine isolante (12) formée sur une partie supérieure (21) en forme de plaque du dissipateur thermique (20) ; et
une couche (13) formant circuit, formée sur une surface de la couche de résine isolante (12),
dans laquelle la couche (13) formant circuit est constituée de cuivre ou d'un alliage de cuivre,
la partie supérieure (21) en forme de plaque du dissipateur thermique (20) a une structure plaquée comprenant une couche d'aluminium (21a) constituée d'aluminium ou d'un alliage d'aluminium et une couche de cuivre (21c) stratifiée sur la couche d'aluminium (21a),
la couche de résine isolante (12) est formée sur une surface de la couche de cuivre (21c),
un rapport ta/tc entre une épaisseur ta de la couche d'aluminium (21a) et une épaisseur tc de la couche de cuivre (21c) est inférieur ou égal à 30,
l'épaisseur ta de la couche d'aluminium (21a) est supérieure ou égale à 2,0 mm et inférieure ou égale à 4,0 mm, et
le dissipateur thermique (20) comprend une ailette de refroidissement (25) faisant saillie à partir de la surface de la partie supérieure (21) en forme de plaque.

2. Substrat de circuit d'isolation (10) intégré à un dissipateur thermique, selon la revendication 1,
dans lequel la couche de résine isolante (12) contient une charge constituée d'un matériau inorganique.
